# EUROPÄISCHE PATENTANMELDUNG

(11) **EP 1 047 291 A1**
(43) Veröffentlichungstag der Anmeldung: **25.10.2000**
(21) Anmeldenummer: 00107548.0
(22) Anmeldetag: 07.04.2000
(51) Int. Cl.: H05K 3/34, H01R 12/36

(54) **Lötbrücke**

(30) Priorität: 24.04.1999 DE 19918746
(71) Anmelder: Diehl AKO Stiftung & Co. KG, 88239 Wangen (DE)
(72) Erfinder: Schotten, Henno, 88260 Argenbühl-Ratzenried (DE)
(74) Vertreter: Hofmann, Gerhard, Dipl.-Ing. Patentassessor

(57) **Zusammenfassung**

Die Erfindung betrifft eine Lötbrücke (1) für mittels Oberflächenmontage bestückbare Leiterplatten (SMD-Platinen), welche aus elektrisch isolierendem Material (2), vorzugsweise aus Leiterplatten-Material besteht. Auf der Oberseite (3) des elektrisch isolierenden Materials (2) ist mindestens eine Leiterbahn (4) und auf der Unterseite (8) sind mindestens zwei elektrische Kontakte (9, 10) aufgebracht, wobei der Abstand der Kontakte der Entfernung der mit Hilfe der Lötbrücke miteinander zu verbindenden Leiterbahnen auf der SMD-Platine entspricht. Die Kontakte (9, 10) auf der Unterseite (8) des elektrisch isolierenden Materials (2) sind mit der mindestens einen Leiterbahn (4) auf der Oberseite (3) elektrisch leitend verbunden.

## Beschreibung

Die Erfindung betrifft eine Lötbrücke für mittels Oberflächenmontage bestückbare Leiterplatten (SMD-Platinen) nach dem Oberbegriff des Anspruches 1.

Bei elektrischen bzw. elektronischen Schaltungen auf Leiterplatten sind auch durch geschicktes Layout Leiterbahnkreuzungen oft nicht zu vermeiden. Die Überbrückung von Leiterbahnen mit Drahtbrücken, wie sie bei herkömmlichen elektronischen Schaltungen mit bedrahteten Bauelementen und rückseitiger Lötung verwendet wurden, ist bei Leiterplatten, welche mittels Oberflächenmontage (SMD-Technologie) bestückt werden, nicht möglich. Deshalb werden für die Oberflächenmontage zur Überbrückung von Leiterbahnen Widerstände in SMD-Technik mit einem Widerstandswert von 0Ω verwendet, die aber wegen ihrer sehr geringen Größe nur für maximal zwei nebeneinander liegende Leiterbahnen verwendbar sind.

Eine andere bekannte Möglichkeit, Leiterbahnen zu überbrücken, ist das Aufbringen einer leitenden Schicht über die vorher mit einer Isolierung versehenen zu überbrückenden Leiterbahn, wobei bei der vorzunehmenden Isolierung Ausnehmungen für die Kontaktierung der überbrückenden Leiterschicht auf der Platine zu berücksichtigen sind. Dieses Verfahren ist sehr aufwendig.

Ausgehend von dem genannten Stand der Technik liegt der Erfindung die Aufgabe zugrunde, eine Lötbrücke für SMD-Platinen zu schaffen, die einfach und mit einer erprobten und eingeführten Technik herzustellen ist und deren Herstellung mit geringem Werkzeugaufwand an verschiedene geometrische und/oder schaltungstechnische Anforderungen angepaßt werden kann.

Diese Aufgabe wird durch eine Lötbrücke der genannten Art mit den Merkmalen des Patentanspruchs 1 gelöst. Weiterbildungen und Ausführungsformen der Erfindung ergeben sich aus den Unteransprüchen.

Grundgedanke der Erfindung ist es, eine Lötbrücke aus elektrisch isolierendem Material, vorzugsweise aus Leiterplatten-Material herzustellen, auf dessen Oberseite mindestens eine Leiterbahn aufgebracht ist und auf dessen Unterseite mindestens zwei elektrische Kontakte aufgebracht sind, deren Abstand der Entfernung der miteinander zu verbindenden Leiterbahnen entspricht, wobei die Leiterbahn auf der Oberseite mit den Kontakten auf der Unterseite des elektrisch isolierenden Materials elektrisch leitend verbunden ist. Diese leitende Verbindung zwischen Ober- und Unterseite erfolgt durch Aufbringen leitender Schichten auf den Seitenflächen des elektrisch isolierenden Materials oder durch Durchkontaktierung von Löchern in dem elektrisch isolierenden Material.

Je nach Anzahl der auf der Oberseite aufgebrachten Leiterbahnen und der auf der Unterseite angebrachten Kontakte sind ein- oder auch mehrfache Lötbrücken herstellbar. Dabei ist in bevorzugter Ausführungsform vorgesehen, mehrere leitende Schichten auf den Seitenflächen des elektrisch isolierenden Materials aufzubringen oder durchkontaktierte Löcher in dem elektrisch isolierenden Material vorzusehen, die mit ein und demselben oder auch mit mehreren Kontakten auf der Unterseite bzw. Leiterbahnen auf der Oberseite elektrisch verbunden sind, je nach Anforderung an die Lötbrücke.

Darüber hinaus können auf der Oberseite des elektrisch isolierenden Materials ein oder mehrere elektrische und/oder elektronische Bauteile aufgebracht sein, die untereinander und/oder mit der bzw. den Leiterbahnen elektrisch verbunden und/oder verschaltet sind. Somit kann die erfindungsgemäße Lötbrücke außer der Aufgabe der Überbrückung von Leiterbahnen auf SMD-Platinen gleichzeitig auch die Funktion von elektrischen/elektronischen Bauteilen bzw. Schaltungen übernehmen.

Die besonderen Vorteile der Erfindung liegen darin, daß die erfindungsgemäße Lötbrücke mit geringem Werkzeugaufwand und mit Hilfe der erprobten und eingeführten Leiterplatten-Technik hergestellt werden kann. Zudem ist es möglich, mit größtenteils gleichem Werkzeug sowohl ein- als auch mehrfache Lötbrücken herzustellen sowie die Herstellung der Lötbrücke mit geringem Werkzeugaufwand an verschiedene geometrische und/oder schaltungstechnische Anfordungen anzupassen.

Im folgenden werden anhand der Zeichnungen drei Ausführungsbeispiele der Erfindung näher erläutert, wobei anzumerken wäre, daß die Erfindung nicht auf die beschriebenen Ausführungsbeispiele beschränkt ist, sondern daß auch zahlreiche weitere Realisierungsmöglichkeiten denkbar sind.

Es zeigen jeweils in perspektivischer Darstellung:
- Figur 1a: eine erste Ausführungsform der erfindungsgemäßen Lötbrücke schräg von oben betrachtet,
- Figur 1b: diese erste Ausführungsform schräg von unten betrachtet,
- Figur 2a: eine zweite Ausführungsform schräg von oben betrachtet,
- Figur 2b: diese zweite Ausführungsform schräg von unten betrachtet,
- Figur 3a: eine dritte Ausführungsform in Form einer dreifachen Lötbrücke schräg von oben betrachtet,
- Figur 3b: diese dritte Ausführungsform schräg von unten betrachtet.

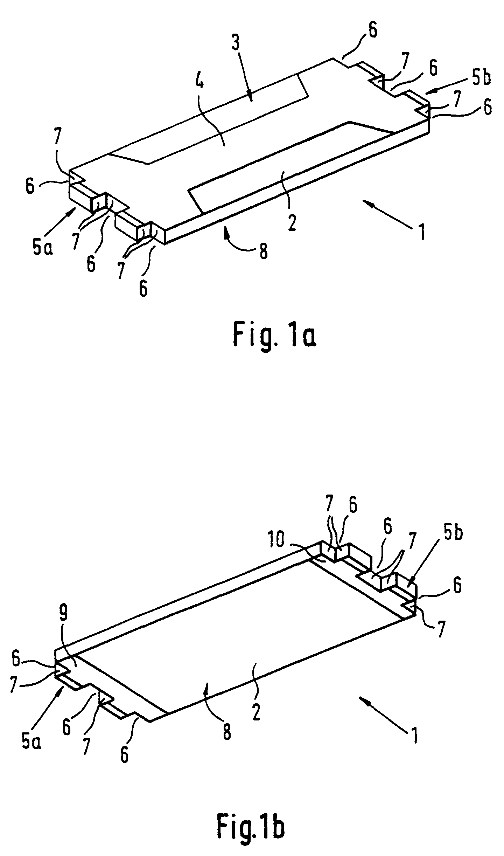

In Figur 1a ist eine erfindungsgemäße einfache Lötbrücke 1 gezeigt, welche aus einem Stück einer Leiterplatte 2 besteht. Auf ihrer Oberseite 3 ist eine elektrische Leiterbahn 4 aufgebracht, welche sich in etwa bzw. fast von einer Stirnfläche 5a der Lötbrücke 1 zur anderen Stirnfläche 5b erstreckt. An den Stirnflächen 5a, b weist die Lötbrücke 1 Ausnehmungen 6 auf. Auf den Seitenflächen 7 der Lötbrücke 1 in den Ausnehmungen 6 sind elektrisch leitende Schichten aufgebracht, welche eine elektrische Verbindung zwischen der Oberseite 3 und der Unterseite 8 der Lötbrücke 1 herstellen.

Auf der in Figur 1b gezeigten Unterseite 8 der Lötbrücke 1 sind zwei Kontakte 9 und 10 aufgebracht, welche mit den leitenden Schichten auf den Seitenflächen 7 in den Ausnehmungen 6 in Kontakt stehen. Auf diese Weise entsteht eine elektrisch leitende Verbindung von dem Kontakt 9 über die elektrisch leitenden Schichten auf den Seitenflächen 7 auf den beiden Stirnseiten 5a und 5b und über die Leiterbahn 4 auf der Oberseite 3 zu dem Kontakt 10.

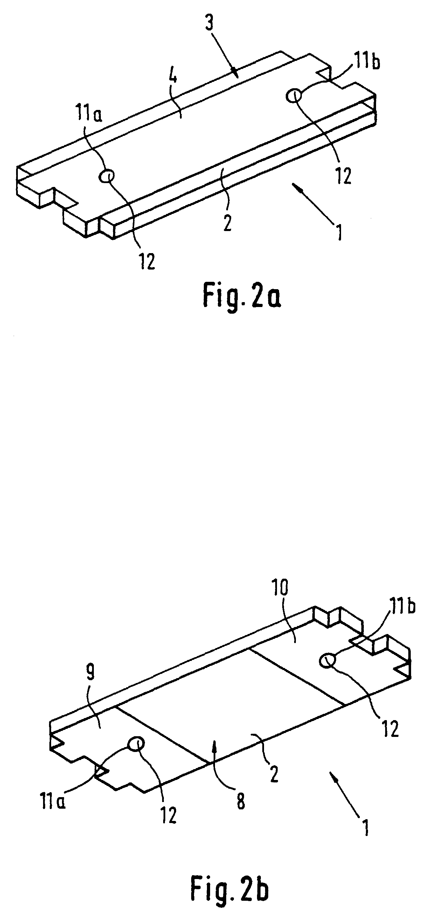

In Figur 2a und 2b ist eine zweite Ausführungsform einer einfachen Lötbrücke 1 gezeigt, bei der die elektrisch leitende Verbindung zwischen der Leiterbahn 4 auf der Oberseite 3 der Leiterplatte 2 mit den Kontakten 9 und 10 auf der Unterseite 8 der Leiterplatte 2 mittels Durchkontaktierung von Löchern 11a und 11b in der Leiterplatte 2, d.h. Aufbringen von elektrisch leitenden Schichten auf den Innenflächen 12 der Löcher 11a und 11b hergestellt ist.

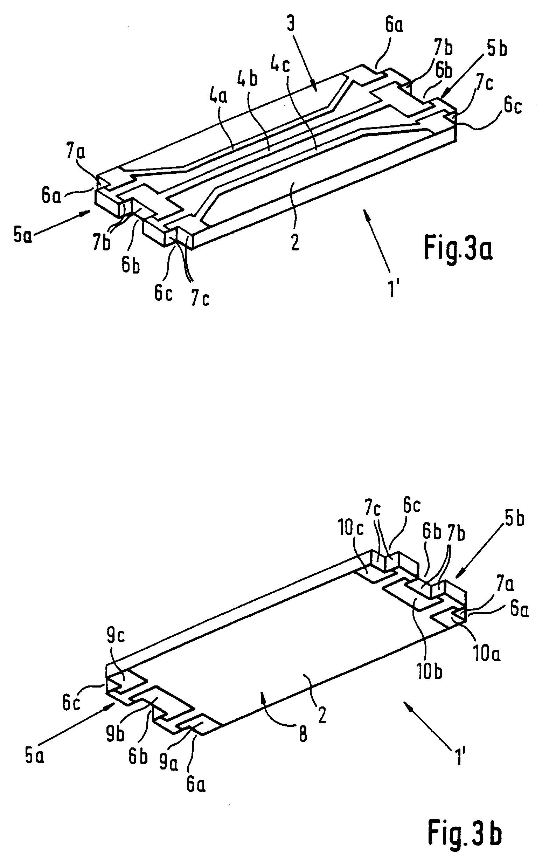

In Fig. 3a und 3b ist eine dreifache Lötbrücke 1' dargestellt, welche aus einem gleichen Stück Leiterplatte 2 wie die beiden vorherigen Ausführungsbeispiele hergestellt ist. Im Unterschied zu diesen weist die dreifache Lötbrücke 1' auf ihrer Oberseite 3 drei Leiterbahnen 4a - c auf, die sich jeweils von den Ausnehmungen 6a - c auf der einen Stirnseite 5a zu den Ausnehmungen 6a - c auf der anderen Stirnseite 5b erstrecken. Auf der Unterseite 8 der dreifachen Lötbrücke 1' sind in nächster Nähe zu den Stirnseiten 5a und 5b jeweils drei Kontakte 9a - c bzw. 10a - c aufgebracht, welche über die elektrisch leitenden Schichten auf den Seitenflächen 7a - c der Ausnehmungen 6a - c jeweils mit den Leiterbahnen 4a - c auf der Oberseite 3 der Lötbrücke 1' elektrisch leitend verbunden sind.

## Patentansprüche

1. Lötbrücke für mittels Oberflächenmontage bestückbare Leiterplatten (SMD-Platinen) mit voneinander getrennten Leiterbahnen, wobei mindestens zwei der Leiterbahnen elektrisch miteinander verbunden werden sollen,
dadurch gekennzeichnet,
daß die Lötbrücke (1) aus elektrisch isolierendem Material (2), vorzugsweise Leiterplatten-Material, besteht,
daß auf der Oberseite (3) des elektrisch isolierenden Materials (2) mindestens eine Leiterbahn (4) aufgebracht ist,
daß auf der Unterseite (8) des elektrisch isolierenden Materials (2) mindestens zwei elektrische Kontakte (9, 10) aufgebracht sind, deren Abstand der Entfernung der miteinander zu verbindenden Leiterbahnen entspricht, und
daß die mindestens eine Leiterbahn (4) auf der Oberseite (3) mit den mindestens zwei Kontakten (9, 10) auf der Unterseite (8) elektrisch verbunden sind.

2. Lötbrücke nach Anspruch 1,
dadurch gekennzeichnet,
daß die elektrische Verbindung der mindestens einen Leiterbahn (4) auf der Oberseite (3) mit den mindestens zwei Kontakten (9, 10) auf der Unterseite (8) durch jeweils mindestens eine elektrisch leitende Schicht auf einer Seitenfläche (7) des elektrisch isolierenden Materials gebildet wird.

3. Lötbrücke nach Anspruch 2,
dadurch gekennzeichnet,
daß die Lötbrücke an ihren Stirnseiten (5a, b) jeweils mehrere Ausnehmungen (6) aufweist, welche durch Aufbringen elektrisch leitender Schichten auf den Seitenflächen (7) des elektrisch isolierenden Materials (2) der elektrischen Verbindung zwischen Ober- und Unterseite dieses Materials dienen.

4. Lötbrücke nach Anspruch 1,
dadurch gekennzeichnet,
daß die elektrische Verbindung der mindestens einen Leiterbahn (4) auf der Oberseite (3) mit den mindestens zwei Kontakten (9, 10) auf der Unterseite (8) mittels Durchkontaktierung jeweils mindestens eines Loches (11a, b) in dem elektrisch isolierenden Material (2) gebildet wird.

5. Lötbrücke nach Anspruch 4,
dadurch gekennzeichnet,
daß die Lötbrücke (1) an beiden Stirnseiten (5a, b) jeweils mehrere durchkontaktierte Locher (11a, b) aufweist.

6. Lötbrücke nach Anspruch 3 oder 5,
dadurch gekennzeichnet,
daß die Ausnehmungen (6) bzw. Löcher (11a) auf der einen Stirnseite (5a) mittels einer Leiterbahn (4) auf der Oberseite (3) der Lötbrücke (1) miteinander und mit den ebenfalls untereinander verbundenen Ausnehmungen (6) bzw. Löchern (11b) auf der anderen Stirnseite (5b) elektrisch leitend verbunden sind und daß die auf einer Stirnseite (5a, b) liegenden Ausnehmungen (6) bzw. Löcher (11a, b) jeweils mit einem Kontakt (9, 10) auf der Unterseite (8) verbunden sind, wodurch eine einfache Lötbrücke (1) gebildet wird.

7. Lötbrücke nach Anspruch 3 oder 5,
dadurch gekennzeichnet,
daß jeweils eine Ausnehmung (6a - c) bzw. ein Loch (11a) auf der einen Stirnseite (5a) mittels einer Leiterbahn (4a - c) auf der Oberseite (3) der Lötbrücke (1') mit einer Ausnehmung (6a - c) bzw. einem Loch (11b) auf der anderen Stirnseite (5b) elektrisch leitend verbunden ist und daß die auf den Stirnseiten liegenden Ausnehmungen (6a - c) bzw. Löcher (11a, b) jeweils mit voneinander getrennten Kontakten (9a - c, 10a - c) auf der Unterseite (8) verbunden sind, wodurch eine mehrfache Lötbrücke (1') gebildet wird.

8. Lötbrücke nach einem der vorherigen Ansprüche,
dadurch gekennzeichnet,
daß auf der Oberseite (3) ein oder mehrere elektrische und/oder elektronische Bauteile aufgebracht sind, die untereinander und/oder mit der mindestens einen Leiterbahn (4) elektrisch verbunden und/oder verschaltet sind.
